Europäisches Patentamt

**European Patent Office**

Office européen des brevets

(11) Veröffentlichungsnummer: **0 013 362**
**B1**

(12) **EUROPÄISCHE PATENTSCHRIFT**

(45) Veröffentlichungstag der Patentschrift:
**23.06.82**

(21) Anmeldenummer: **79105058.6**

(22) Anmeldetag: **10.12.79**

(51) Int. Cl.³: **H 01 L 23/42**

(54) Vorrichtung zur Wärmeübertragung, insbesondere für integrierte Schaltungen.

(30) Priorität: **02.01.79 US 48**

(43) Veröffentlichungstag der Anmeldung:
**23.07.80 Patentblatt 80/15**

(45) Bekanntmachung des Hinweises auf die Patenterteilung:
**23.06.82 Patentblatt 82/25**

(84) Benannte Vertragsstaaten:
**DE FR GB**

(56) Entgegenhaltungen:
**DE-A-2 429 985**
**US-A-2 958 021**
**IBM TECHNICAL DISCLOSURE BULLETIN,**
**Band 17, Nr. 11, April 1975, Seite 3313**
**New York, U.S.A.**
**H. PARSAPOUR: »Modular heat sink«**
**IBM TECHNICAL DISCLOSURE BULLETIN,**
**Band 20, Nr. 5, Oktober 1977,**
**Seiten 1769—1771**
**New York, U.S.A.**
**B. T. CLARK et al.: »Cooling device for**
**multilayer ceramic modules«**

(73) Patentinhaber: **International Business Machines Corporation, Armonk, N.Y. 10504 (US)**

(72) Erfinder: **Andros, Frank Edward, 66 Davis Street, Binghamton, NY 13905 (US)**
Erfinder: **Shay, Robert John Eugene, R.D. No. 1, Bath, Ny 14810 (US)**

(74) Vertreter: **Böhmer, Hans Erich, Dipl.-Ing., Schönaicher Strasse 220, D-7030 Böblingen (DE)**

Vorrichtung zur Wärmeübertragung, insbesondere für integrierte Schaltungen

Bei der heutigen Technik der integrierten Schaltungen werden im allgemeinen metallisierte keramische Moduln verwendet, die über steckbare Kontakte auf gedruckten Schaltungskarten und -platten angebracht werden können. Diese Moduln bestehen dabei aus einem keramischen Substrat als Grundplatte, auf der eine gedruckte Schaltung angebracht ist, an der ein aus Silicium bestehendes Halbleiterplättchen oder mehrere solcher Halbleiterplättchen angelötet sind. Für eine hermetische Abdichtung ist für dieses Modul eine Abdeckhaube oder Kappe vorgesehen. In diesen Halbleiterplättchen sind Schaltkreise vorgesehen, wie zum Beispiel Treiberstufen für Speicher, Abfühl- oder Leseverstärker, Operationsverstärker und logische Schaltkreise für diese Schaltungen. Diese mit elektronischen Schaltungen versehenen Halbleiterleiterplättchen führen dabei die jeweiligen, für die Maschine erforderlichen elektronischen Funktionen durch und erzeugen dabei im Betrieb beträchtliche Wärmemengen, deren Ableitung beträchtliche Schwierigkeiten bereitet.

Für derartige, mit integrierten Schaltungen versehene Moduln hat man Wärmeübertragungsvorrichtungen oder Wärmesenken vorgesehen. Man hat dabei beispielsweise die Wärmeableitung vom Halbleiterplättchen über einen Kolben nach einer geeigneten Kühlplatte benutzt, man hat Kühlrippen angesetzt und Luftkühlung oder Flüssigkeitskühlung verwendet. Ferner hat man in den Zwischenraum zwischen dem Halbleiterplättchen und der das Modul umschließenden Kappe ein wärmeübertragendes Fett, ein wärmeleitendes Pulver oder ein flüssiges Metall eingebracht.

Diese der Wärmeableitung dienenden Vorrichtungen nehmen normalerweise einen relativ großen Raum ein und benutzen ziemlich kritische Materialien. Sie sind außerdem relativ teuer in der Herstellung, groß und ziemlich schwer.

In neuerer Zeit sind zwei ziemlich neue Verfahren für die Kühlung von Schaltkreisen eingesetzt worden, die die Thermoumlaufkühlung bzw. ein Wärmerohr verwenden. Bei der Thermoumlaufkühlung wird ein Behälter verwendet, in dem ein flüssiges Kühlmittel in einem Verdampferabschnitt vorgesehen ist, das bei Wärmezufuhr verdampft, worauf im Kondensatorabschnitt dieser Dampf unter Abgabe von Wärme kondensiert. Die Thermoumlaufkühlung benutzt von außen einwirkende Kräfte, wie zum Beispiel die Schwerkraft, damit das Kondensat in vertikaler Richtung längs der Seitenwände des Behälters nach dem Verdampferabschnitt zurücklaufen kann. Das Wärmerohr verwendet ebenfalls einen Behälter, in dem sich in einem Verdampferabschnitt ein flüssiges Kühlmittel befindet, das bei Zufuhr von Wärme verdampft, worauf dieser Dampf unter Abgabe von Wärme in einem Kondensatorabschnitt kondensiert. Das Wärmerohr verwendet die Kapillarwirkung eines Dochtes für den Rücklauf des Kondensats nach dem Verdampferabschnitt. Die Wärmeumlaufkühlung ist infolge der für den kontinuierlichen Kondensatrücklauf erforderlichen äußeren Kräften lageempfindlich. Das Wärmerohr ist wegen der Verwendung eines innen liegenden Dochtes eine relativ teuere Wärmeübertragungsvorrichtung, und dies ist insbesondere dann zutreffend, wenn als Behälter ein flexibler Balg benutzt wird. Für die Anwendung in mit integrierten Schaltungen versehenen Moduln wird für die Wärmeübertragung ein flexibler Balg bevorzugt, damit die auf das Halbleiterplättchen und die Lötstützpunkte ausgeübten Kräfte, die sich aus der Gesamtheit der Toleranzen des Halbleiterplättchens, des Substrats und der Kappe oder Haube ergeben, möglichst klein gehalten werden. Es hat sich als besonders wünschenswert herausgestellt, eine mit einem Balg versehene Wärmeübertragungsvorrichtung zu schaffen, die von äußeren Kräften unabhängig ist und die für einen kontinuierlichen Betrieb keinen Docht benötigt.

Durch die vorliegende Erfindung wird eine Vorrichtung zur Wärmeübertragung geschaffen, welche für ununterbrochenen Betrieb von äußeren Kräften unabhängig ist und keinen Docht benötigt. Dies wird gemäß der Erfindung dadurch erreicht, daß bei Zufuhr von Wärme im Verdampferabschnitt etwa im Zentrum des Behälters eine stabile Dampfblase entsteht, und Dampf durch die Dampfblase nach dem Kondensatorabschnitt strömt, wo er unter Abgabe von Wärme kondensiert, worauf das Kondensat zur Ergänzung der im Verdampferabschnitt befindlichen Kühlflüssigkeit in einem kontinuierlichen Flüssigkeitsstrom am Rande der Dampfblase zum Verdampferabschnitt zurückfließt.

Der vorzugsweise als Balg ausgebildete Behälter ist dabei nicht vollständig mit Flüssigkeit gefüllt, wodurch sich im Innern eine Dampfblase bilden kann. Die aus der Dampfphase des Kühlmittels bestehende Blase ist dabei in der Mitte des Behälters angeordnet. Diese erstmalig beobachtete Zentrierung der Dampfblase läßt sich auf die Oberflächenspannungseigenschaften der Flüssigkeit zurückführen. Da die Dampfblase innerhalb des geschlossenen Systems stabil ist, ist der Rücklauf des flüssigen Kondensats unabhängig von der Ausrichtung der Vorrichtung in bezug auf äußere Kräfte, wie z. B. die Schwerkraft.

Die Wärmezufuhr im Verdampferabschnitt der Kapsel bewirkt ein Bläschensieden oder eine Verdampfung der Flüssigkeit an der Trennfläche zwischen flüssiger und Dampfphase. Der Dampf strömt quer durch die Dampfblase und kondensiert an der gegenüberliegenden Seite, wo die Wärme abgegeben wird, und die Flüssigkeit im Verdampfungsabschnitt wird durch den Rücklauf über einen kontinuierlichen Flüssigkeitsfilm ergänzt. Man kann verschiedene Gleichgewichts-Betriebsbedingungen der Vorrichtung und die Größen der Dampfblase durch Auswahl einer geeigneten Arbeitsflüssigkeit bestimmen. Da die Vorrichtung nur die Flüssigkeit und ihren Dampf im Gleichgewichtszustand enthält, wird der Betriebsdruck durch das Verhältnis zwischen Dampfdruck und Temperatur der ausgewählten Flüssigkeit bestimmt. Daher sind Flüssigkeiten mit einem relativ flachen Verlauf der Kennlinie für den Dampfdruck über der Temperatur für solche Anwendungsgebiete erwünscht, wo nur geringe Druckänderungen auftreten sollen, und umgekehrt.

Die Tatsache, daß dieser im folgenden als Thermokapsel bezeichnete Behälter ein abgeschlossenes System darstellt, gestattet seine Anwendung in solchen Fällen, wo eine unmittelbare Berührung mit der Betriebsflüssigkeit nicht zulässig ist, und ergibt eine Wärmeübertragungsvorrichtung mit hohem Wirkungsgrad, die mit Vorteil die Enthalpie Verdampfung/Kondensation ausnutzt. Dabei können ohne merkliche Temperaturunterschiede beträchtliche Wärmemengen freigesetzt bzw. absorbiert werden bei hohen Wärmeübertragungsgeschwindigkeiten. Diese Thermokapsel kann dabei auf vielen Gebieten der Technik eingesetzt werden, wie z. B. der Kühlung elektronischer Bauelemente, als isothermischer elektronischer Schalter und beim Enteisen von Mikrominiaturstrukturen.

Ein weiterer Vorteil dieser Thermokapsel besteht darin, daß durch die Konstruktion ein fortlaufender Betrieb möglich ist, der über einen weiten Bereich dieser Betriebsbedingungen unabhängig ist vom Betriebsdruck, von der Temperatur und von äußeren Kräften. Die kontinuierliche Strömungsbahn für die Flüssigkeit ist in sich stabil und bewirkt damit einen Rücklauf der Flüssigkeit.

Die Erfindung wird nunmehr anhand eines Ausführungsbeispiels und dessen Anwendung in Verbindung mit den beigefügten Zeichnungen im einzelnen erläutert.

In den Zeichnungen zeigt

Fig. 1 zum Stand der Technik die Arbeitsweise einer Vorrichtung zur Wärmeübertragung mit Thermoumlaufkühlung,

Fig. 2 den Betrieb einer Vorrichtung zur Wärmeübertragung gemäß dem Stande der Technik unter Verwendung eines Wärmerohrs,

Fig. 3a–3d die Bildung und den Betrieb einer Vorrichtung zur Wärmeübertragung gemäß der Erfindung und

Fig. 4 die Anwendung der Erfindung als Thermokapsel mit einem Balg für die Kühlung von elektronischen Bauelementen.


## Beschreibung der bevorzugten Ausführungsform

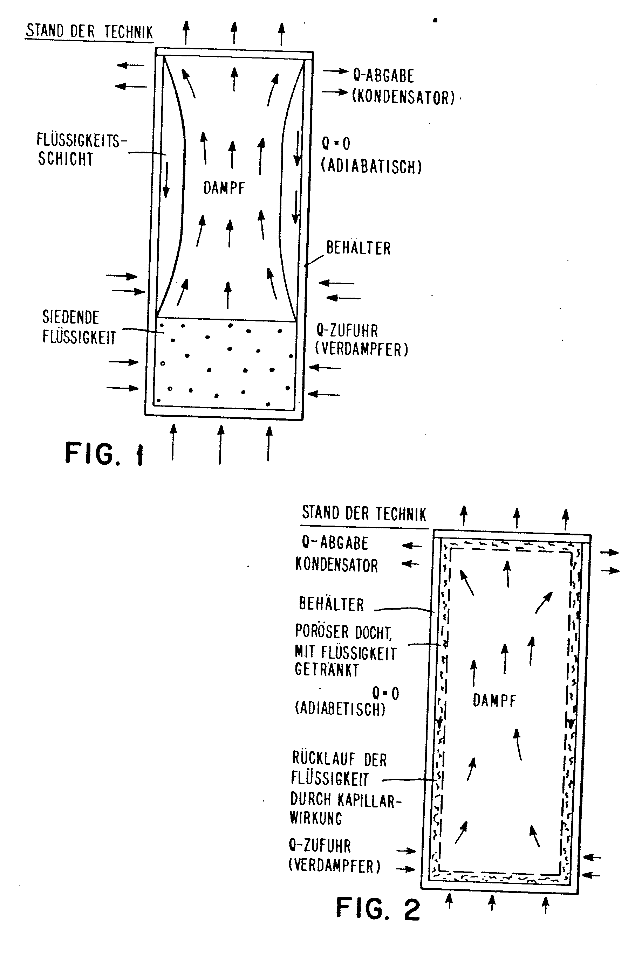

Zunächst sollen unter Hinweis auf Fig. 1 und 2 zwei neuerdings verwendete Verfahren zum Kühlen elektronischer Bauelemente beschrieben werden. Fig. 1 zeigt dabei eine Thermoumlaufkühlung mit einem dicht verschlossenen Behälter mit einem Verdampferabschnitt, in dem sich eine Flüssigkeit befindet, die bei Wärmezufuhr von außen zu sieden beginnt, verdampft, worauf dieser Dampf in den Kondensatorabschnitt strömt und dort unter Abgabe von Wärme kondensiert. Die Wärmeumlaufkühlung benötigt von außen einwirkende Kräfte, wie z. B. die Schwerkraft, damit das Kondensat als Flüssigkeitsfilm in senkrechter Richtung längs der Seitenwände nach dem Verdampferabschnitt zurücklaufen kann. Fig. 2 zeigt die übliche Konstruktion mit Wärmerohr unter Verwendung eines dicht verschlossenen Behälters mit einem mit Flüssigkeit getränktem Docht und Wärmezufuhr in einem Verdampferabschnitt, so daß an der Oberfläche des Dochtes eine Verdampfung eintritt und der dabei entstehende Dampf unter Abgabe von Wärme in einem Kondensatorabschnitt kondensiert.

Das Wärmerohr benutzt die Kapillarwirkung des porösen Dochtes für den Rücklauf des Kondensats nach dem Verdampferabschnitt.

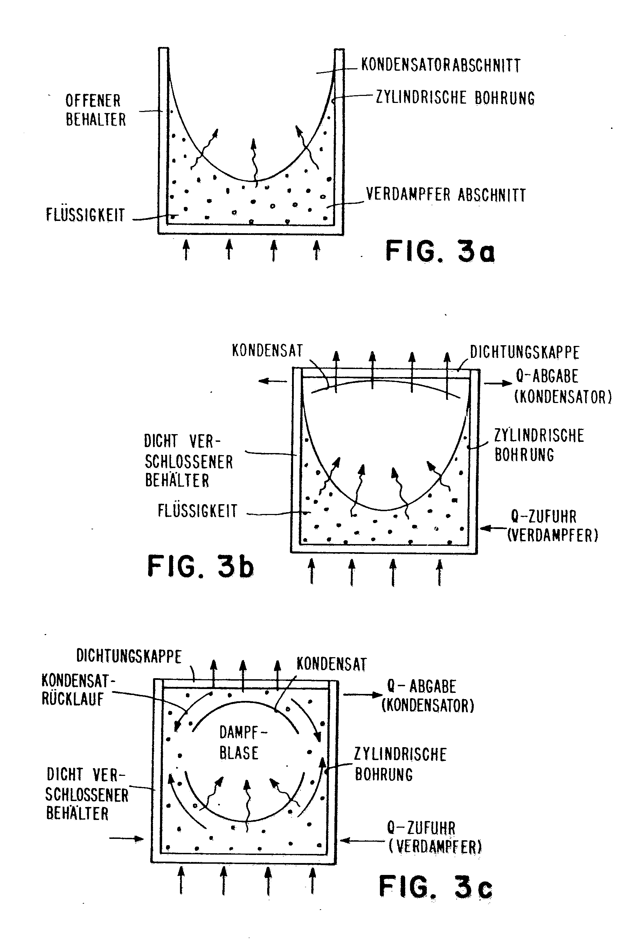

In den Fig. 3a bis 3d sind der erfinderische Grundgedanke der als Vorrichtung zur Wärmeübertragung verwendeten Thermokapseln gemäß der Erfindung dargestellt, welche von einer in der Mitte einer Flüssigkeit liegenden Gasblase Gebrauch macht und damit einen kontinuierlichen Umlauf eines flüssigen Kühlmittels schafft. Fig. 3a bis 3d sind stark vergrößert dargestellt, um zu zeigen, wie sich die Dampfblase bildet.

Wie aus Fig. 3a zu erkennen, besteht der Behälter aus einem festen Material, wie zum Beispiel Kupfer, und enthält einen oben offenen zylindrischen Innenraum, in dessen unteren Teil, d. h. in dem sogenannten Verdampferabschnitt, eine Kühlflüssigkeit vorgesehen ist. Es wurde festgestellt, daß sich dann ein stabile Dampfblase bildet, wenn man Flüssigkeiten wie Äthanol, Wasser, Azeton und 2-Propanol in Behältern verwendet, deren Hauptabmessungen zwischen 1,25 mm bis 7,6 mm liegen, wobei die Länge des zylindrischen Innenraums etwa gleich dem Durchmesser ist. Die Obergrenze für die Größe des Behälters wird durch die Oberflächenspannung der verwendeten Flüssigkeit bestimmt. Es ist dabei sehr wichtig, daß die gesamte Luft oder alle nicht kondensierbaren Gase aus dem Behälter entfernt werden, damit sich die Dampfblase bilden kann. Ein zum Füllen des Behälters mit einer Kühlflüssigkeit verwendbares Verfahren besteht darin, so lange durch Zufuhr von Wärme eine Verdampfung in Gang zu setzen, bis die gewünschte Menge an Kühlflüssigkeit in dem Behälter zurückbleibt und dann den Behälter durch eine Kappe dicht zu verschließen. Die Wärme wird dabei so lange zugeführt, bis die Temperatur auf etwa 5°C bis 6°C unterhalb des Siedepunktes der Kühlflüssigkeit angestiegen ist, was ziemlich nahe am Sättigungspunkt bei Atmosphärendruck liegt und ausreicht, die gesamte Luft und alle nicht kondensierbaren Gase auszutreiben. Die Verdampfung kann dabei zeitlich überwacht werden, z. B. kann die gesamte Vorrichtung während der Verdampfung gewogen werden. Andererseits könnte man auch eine übliche Vakuumpumpe und eine Ventilanordnung einsetzen.

In Fig. 3b wird die abzuführende Wärmemenge Q dem Verdampferabschnitt des Behälters zugeführt, der an seiner oberen Seite mit einer Kappe dicht verschlossen ist, so daß die Flüssigkeit verdampft. Der Dampf steigt nach oben und kondensiert an der Unterseite der Kappe des Behälters.

In der nächsten, in Fig. 3c dargestellten Stufe wird die abzuführende Wärmemenge Q kontinuierlich dem Verdampferabschnitt zugeführt. Unter Hinweis auf die in Fig. 3c gezeigten Richtungspfeile steigt der dabei entstehende Dampf nach oben und bildet ein Kondensat, das nunmehr an den Seiten des Behälters nach unten zurückfließt. Wenn dieses zurückfließende Kondensat in Berührung mit der im Verdampferteil befindlichen Flüssigkeit kommt, bildet sich eine Dampfblase, die sich jedoch noch nicht in ihrem stabilen Zustand befindet. Vielmehr verursacht die Oberflächenspannung der Flüssigkeit eine Umverteilung der Flüssigkeit, die nunmehr aus dem Flüssigkeitsvorrat im Verdampferabschnitt rund um die Dampfblase herum strömt. Die Dampfblase wird nun nach unten gezogen und ersetzt das Flüssigkeitsvolumen, das aus dem Flüssigkeitsvorrat nach oben ausgewandert ist, und die Dampfblase wird dadurch im wesentlichen in der Mitte des Behälters stabilisiert.

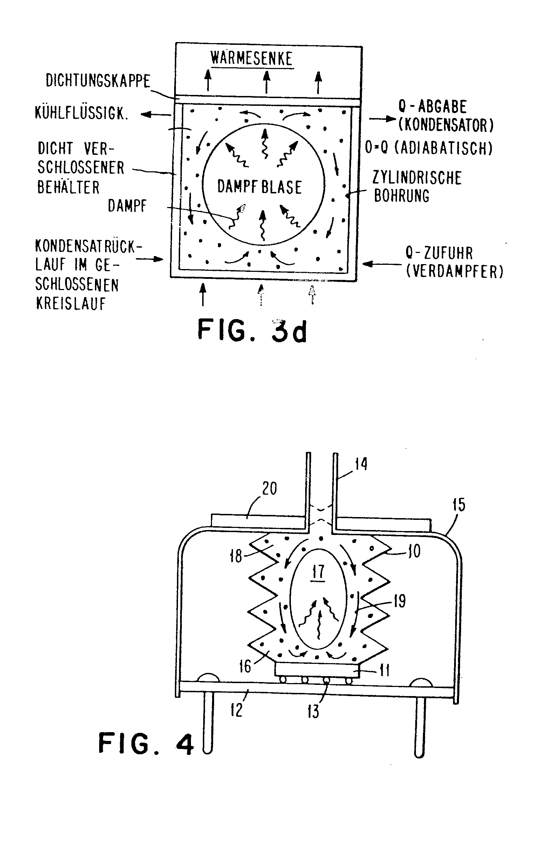

In Fig. 3d ist nunmehr die letzte Stufe des Betriebszustandes der Thermokapsel dargestellt. Die Dampfblase nimmt dabei die Form einer Kugel an, und dies ist die stabilste Form der Dampfblase. Im Betrieb der Vorrichtung bewirkt die im Verdampferabschnitt zugeführte Wärme ein Bläschensieden oder Verdampfen der Flüssigkeit an der Grenzfläche zwischen flüssiger und dampfförmiger Phase. Wie durch die Richtungspfeile angedeutet, strömt der Dampf durch die Dampfblase hindurch und kondensiert an der gegenüberliegenden Seite, wo die Wärme abgegeben wird. Der Flüssigkeitsstand in dem Verdampferabschnitt wird durch den Rückfluß des Kondensats über einen kontinuierlichen Flüssigkeitsfilm aufgefüllt. Die Wärme kann dabei an eine übliche Wärmesenke, wie z. B. an eine einen Luftstrom führende Leitung abgegeben werden. Die Betriebsbedingungen im Gleichgewichtszustand der Vorrichtung und die Größe der Dampfblase können durch entsprechende Auswahl der Arbeitsflüssigkeit verändert werden. Da die Vorrichtung nur die Flüssigkeit und den daraus gebildeten Dampf im Gleichgewicht enthält, wird der Betriebsdruck durch das Verhältnis von Dampfdruck zu Temperatur der ausgewählten Flüssigkeit bestimmt. Daher sind Flüssigkeiten mit einem relativ flachen Verlauf der Kennlinie des Dampfdruckes über der Temperatur für solche Anwendungsgebiete vorzusehen, bei der nur geringfügige Änderungen im Druck erwünscht sind und umgekehrt. Der Druckanstieg beträgt dabei beispielsweise für Freon 113 jeweils 15,2 mm Quecksilbersäule für jede Zunahme der Temperatur um 1°C, während für 1.2 Äthandiol der Druckanstieg 0,25 mm Quecksilbersäule je Temperaturzunahme um 1°C im Bereich zwischen 50°C und 90°C beträgt. Für bestimmte Anwendungsgebiete lassen sich daher nahezu isobare oder isotherme Betriebsbedingungen einstellen. Da die Form der Dampfblase innerhalb des abgeschlossenen Systems stabil ist, ist der Umlauf des flüssigen Kondensats unabhängig von der Ausrichtung der Vorrichtung in bezug auf die Schwerkraft und außerdem sind keine teueren Dochte im Innern der Vorrichtung erforderlich.

Der Vorteil der stabilen Dampfblase ergibt sich aus einer einmaligen Erscheinung innerhalb des die Thermokapsel darstellenden Behälters, wenn dessen Abmessungen auf den Krümmungsradius der Flüssigkeitsoberfläche verringert werden. Unterhalb dieser Abmessungen bewirkt die Kraft der Oberflächenspannung eine Involution der Oberfläche, wodurch sich in der Mitte des abgeschlossenen Systems eine Dampfblase bildet. Daher kann eine solche Thermokapsel auch mit Abmessungen aufgebaut werden, die viel kleiner sind als der Involutionsradius der Flüssigkeit, und läßt sich daher für einen weiten Bereich von Anwendungsgebieten in der Mikrominiaturisierung einsetzen. Wie in Fig. 3a gezeigt, sollte der Meniskus des Flüssigkeitsvorrats vorzugsweise konkav ausgebildet sein, wodurch die Bildung der Dampfblase begünstigt wird. Die Ausbildung des Meniskus wird durch die zwischen der Kühlflüssigkeit und dem Material des Behälters zur Einwirkung kommenden Kraft bestimmt. Die Oberflächenspannung zwischen den Flüssigkeiten und dem Material des Behälters ergibt die gewünschte konkav gekrümmte obere Oberfläche der Kühlflüssigkeitssäule, da die Seitenwände des Behälters durch die Kühlflüssigkeit bei der oben beschriebenen Art der Füllung benetzt werden.

Die oben beschriebene Thermokapsel läßt sich z. B. vorteilhafterweise für die innere thermische Verbesserung metallisierter, keramischer oder mehrschichtiger keramischer Moduln einsetzen, die mindestens ein mit integrierten Schaltungen versehenes Halbleiterplättchen aufweisen, das über Lötstützpunkte mit dem keramischen Substrat verbunden ist. Bisher gebräuchliche Moduln, die diese Art von thermischer Verbesserung nicht enthalten, werden normalerweise dadurch gekühlt, daß man die auf dem Halbleiterplättchen entstehende Wärme über die Lötstützpunkte nach dem Substrat, nach der Abdeckhaube des Moduls und nach den Kontaktstiften und der gedruckten Schaltungskarte oder gedruckten Schaltungsplatte abführt, in das das Modul mit den Kontaktstiften eingesteckt ist. Eine übliche innere Wärmeableitung sieht eine parallele unmittelbare Wärmeableitung von dem Halbleiterplättchen nach der Abdeckhaube oder Abdeckkappe vor, wodurch die Verlustleistung des Bauelements erhöht werden kann. Eine Voraussetzung für diese Art der thermischen Verbesserung besteht darin, daß diese zweite Wärmebrücke biegsam oder nachgiebig sein soll, damit die auf das Halbleiterplättchen und die Lötstützpunkte ausgeübten Kräfte, die sich aus den verschiedenen Toleranzen auf dem Halbleiterplättchen, dem Substrat und der Abdeckhaube ergeben können, möglichst klein gehalten werden.

In F i g. 4 ist nun die Anwendung des Thermokapsel-Konzeptes gemäß der Erfindung auf eine als Mikrobalg ausgestaltete Thermokapsel 10 dargestellt, die sich insbesondere für die Kühlung eines integrierte Schaltungen enthaltenden Halbleiterplättchens 11 eignet, das an einem Substrat 12 eines Moduls über Lötstützpunkte 13 befestigt ist. Die den Behälter darstellende, als Mikrobalg ausgebildete Thermokapsel 10 ermöglicht die Absorption von Zug- und Druckspannungen in dem System während des Betriebes und stellt außerdem eine metallurgische Verbindung zwischen Halbleiterplättchen und Abdeckhaube her, die unabhängig von den Toleranzen des Gesamtsystems ist. Außerdem wird dadurch die außergewöhnliche gute Wärmeübertragung, die sich bei Verdampfung und Kondensation ergibt, innerhalb des Moduls ausgenutzt. Derartige Mikroblage sind auf dem Markt erhältlich und bilden einen hermetisch abgeschlossenen Behälter, der ein Auslaufen des Kühlmittels oder ein Eindringen von Verunreinigungen verhindert, so daß die gewünschten Gleichgewichtsbedingungen erhalten bleiben. Die Thermokapsel kann außerdem durch eine metallische Trennfläche aus Lötmittel an einer lötbaren Oberfläche auf der Innenseite der Abdeckhaube des Moduls und auf der Rückseite des Halbleiterplättchens befestigt werden. Da die Rückseite des Halbleiterplättchens passiviert werden kann, wird keine elektrisch leitende Verbindung nach der Abdeckhaube hergestellt, und man erhält trotzdem eine ausgezeichnete thermische Verbindung.

Entsprechend der Darstellung ist die als Mikrobalg ausgebildete Thermokapsel 10 vorzugsweise zylindrisch und weist einen ebenso zylindrischen Innenraum auf und besitzt vorzugsweise an einem Ende ein Füllrohr 14, das aus einem weichen Material, wie z. B. Kupfer, bestehen kann, durch welches die Kühlflüssigkeit nach dem Zusammenbau des Moduls eingeführt werden kann. Beim Zusammenbau der als Mikrobalg ausgebildeten Thermokapsel 10 mit dem Modul wird ein lötbares Metall, wie z. B. Gold, auf die Rückseite des Halbleiterplättchens während der Fertigung der Halbleiterscheibe, aus der das Halbleiterplättchen herausgesägt wird, aufgedampft. Eine Passivierungsschicht aus Siliciumoxid wird vor der Aufdampfung des Metalls zur Sicherstellung einer elektrischen Isolation aufgebracht.

Die als Mikrobalg aufgebaute Thermokapsel 10 besteht aus einem lötbaren Material, wie z. B. Nickel oder Kupfer, und die Innenseite der Abdeckhaube 15 für das Modul kann mit einem stromlos oder elektrolytisch aufgebrachten Überzug aus Kupfer versehen sein. Für die Verbindung der aus einem Mikrobalg bestehenden Thermokapsel 10 mit der Innenseite der Abdeckhaube und der Rückseite des Halbleiterplättchens wird dann eine Lötverbindung oder ein Gold-Zinn-Eutektikum verwendet. Diese Verbindung wird in einem Ofen hergestellt, wie er normalerweise für die Befestigung von Halbleiterplättchen auf Substraten eingesetzt wird.

Nach dem Zusammenbau kann eine Injektionsspritze für die vollständige Füllung der als Mikrobalg ausgebildeten, als Behälter dienenden Thermokapsel 10 mit einer Kühlflüssigkeit verwendet werden. Anschließend wird dem Verdampferabschnitt 16 so lange Wärme zugeführt, bis die Temperatur der Kühlflüssigkeit etwa 5°C bis 6°C unter ihrem Siedepunkt liegt, so daß die Kühlflüssigkeit durch das offene Einfüllröhrchen so lange verdampfen kann, bis die Kühlflüssigkeit etwa ein Drittel ihres ursprünglichen Volumens angenommen hat und eine Dampfblase sich zu bilden beginnt. Nunmehr wird das Einfüllröhrchen durch Zusammendrücken beispielsweise mit einer Krimpzange abgedichtet. Zu diesem Zeitpunkt wird somit die Thermokapsel 10 verschlossen und befindet sich damit im gleichen Zustand wie der in Fig. 3c gezeigte Behälter.

Wird das Modul jetzt in Betrieb genommen, dann wird die von dem Halbleiterplättchen 11 ausgehende Wärme die Kühlflüssigkeit im Verdampferabschnitt 16 der Thermokapsel 10 so weit erwärmen, daß sie zu verdampfen beginnt, so daß die in Zusammenhang mit Fig. 3d beschriebene Wirkung eintritt. Eine stabile Dampfblase 17 wird dabei im wesentlichen in der Mitte der Thermokapsel 10 gebildet, und der im Verdampferabschnitt 16 erzeugte Dampf strömt quer durch die Dampfblase 17 und kondensiert im Kondensatorabschnitt 18 auf der anderen Seite, wo die Wärme dann abgegeben wird. Die Flüssigkeit wird im Verdampferabschnitt 16 dadurch wieder nachgefüllt, daß das Kondensat entsprechend dem Pfeil 19 durch einen kontinuierlichen Flüssigkeitsfilm zurückgeführt wird. Eine geeignete Wärmesenke 20 kann auf der Oberseite der Abdeckhaube des Moduls befestigt sein. Die Wärmesenke 20 kann dabei zum Abführen der Wärme Wasser, eine Luftströmung, wärmeleitendes Fett oder dergleichen verwenden.

Im Betrieb des Moduls erfolgt die Ableitung der in dem Halbleiterplättchen entstehenden Wärme an den Verbindungsstellen mit dem Halbleiterplättchen. Bei der derzeit üblichen Technik nimmt bei zunehmender Temperatur dieser Verbindungen die Lebensdauer des Halbleiterplättchens ab. Verwendet man die als Mikrobalg ausgebildete Thermokapsel 10, dann kann man durch Auswahl der entsprechenden Kennlinie des Dampfdruckes über der Temperatur der Kühlflüssigkeit und der Einfüllmenge die Temperatur dieser Verbindungsstellen beträchtlich unter die bisher üblichen Betriebstemperaturen an diesen Verbindungsstellen absenken, so daß die Wärmeausdehnung zwischen den Lötzstützpunkten und dem Substrat zu einem Minimum wird, wodurch die Lebensdauer der Lötstützpunkte wesentlich verbessert wird. Durch Auswahl des Betriebsdruckes können die Lötzstützpunkte außerdem durch Konstruktion auf Zugspannung oder Druckspannung beansprucht werden, was ebenfalls dazu beiträgt, die Lebensdauer dieser Lötstützpunkte zu erhöhen.

Durch Einsatz dieser neuen Thermokapsel 10 ist mit der Zusammensetzung des Behälters eine gelötete oder eutektische metallische Verbindung sowohl mit der Abdeckhaube als auch mit dem Halbleiterplättchen mit einer angenäherten Dicke von 0,05 mm möglich, so daß sich eine Lötverbindung mit sehr geringem Wärmeübergangswiderstand erzielen läßt. Unter der Annahme einer Dicke der Lötverbindung von 0,05 mm vom Halbleiterplättchen 11 nach der Thermokapsel 10 und von der Thermokapsel 10 nach der Abdeckhaube 15, wobei die Materialstärke des die Thermokapsel 10 bildenden, aus Kupfer bestehenden Behälters etwa 0,38 mm beträgt, zeigt die nachfolgende Tabelle, daß eine Verringerung des inneren Wärmeleitwiderstandes $R_{int}$ (Grad Celsius je Watt) um eine Größenordnung in bezug auf genormte metallisierte keramische Produkkte (Std. Mod.) möglich ist, die jedoch keine wesentliche thermische Verbesserung enthalten, und daß eine vierfache Verringerung in bezug auf ein Modul möglich ist, das eine Wärmesenke aus einem wärmeleitenden Fett (W/Fett) bei einer Größe des Halbleiterplättchens von 8,9 mm × 8,9 mm aufweist.

Typische Wärmeleit-Eigenschaften

| Größe eines quadratischen Halbleiterplättchens | Anzahl der Lötverbindungen | $R_{int}$ °C/Watt | | |
|---|---|---|---|---|
| | | Standard Modul | W/Fett | W/Thermokapsel |
| 4,1 mm | 48 | 20,6 | 6,0 | 2,8 |
| 6,0 mm | 82 | 13,1 | 4,5 | 1,2 |
| 8,9 mm | 130 | 8,9 | 2,3 | 0,6 |

Diese neue Thermokapsel kann bei der derzeitigen Technik der Herstellung von Halbleitermoduln mit sehr geringem oder gar keinem Einfluß auf die Konstruktion des Moduls und auf die Lötverfahren eingeführt werden und läßt sich in den heute üblichen Verfahrensabläufen einsetzen. Falls notwendig, können geringfügige Änderungen zulässig sein. Durch Aufheizen in einer unter Druck stehenden Stickstoffatmosphäre auf Löttemperatur läßt sich die Abdeckhaube 15 und die als Mikrobalg ausgebildete Thermokapsel 10 entfernen.

**Patentansrpüche**

1. Vorrichtung zur Übertragung von Wärme, mit einem geschlossenen, einen Verdampferabschnitt (16) und einen Kondensatorabschnitt (18) aufweisenden Behälter (10) und einer in dem Verdampferabschnitt (16) vorgesehenen Kühlflüssigkeit, dadurch gekennzeichnet,
daß das Volumen der Kühlflüssigkeit, dessen Oberflächenspannung und die Abmessungen des Behälters so aufeinander abgestimmt sind,
daß bei Zufuhr von Wärme im Verdampferabschnitt (16) etwa im Zentrum des Behälters eine stabile Dampfblase (17) entsteht und Dampf durch die Dampfblase (17) nach dem Kondensatorabschnitt (18) strömt, wo er unter Abgabe von Wärme kondensiert, worauf das Kondensat zur Ergänzung der im Verdampferabschnitt (16) befindlichen Kühlflüssigkeit in einem kontinuierlichen Flüssigkeitsstrom am Rande der Dampfblase zum Verdampferabschnitt (16) zurückfließt.
2. Vorrichtung nach Anspruch 1, dadurch gekennzeichnet, daß der Behälter (10) einen zylindrischen Innenraum aufweist, an dessen Ende sich der Verdampferabschnitt (16) und an dessen anderen Ende sich der Kondensatorabschnitt (18) befindet.
3. Vorrichtung nach Anspruch 2, dadurch gekennzeichnet, daß die Kühlflüssigkeit einen konkaven Meniskus aufweist.
4. Vorrichtung nach den Ansprüchen 2 oder 3, dadurch gekennzeichnet, daß die Länge des Behälters (10) etwa gleich dessen Durchmesser ist.
5. Vorrichtung nach Anspruch 4, dadurch gekennzeichnet, daß die zylindrische Wand des Behälters (10) in Form eines Balges ausgebildet ist.
6. Vorrichtung nach Anspruch 5, dadurch gekennzeichnet, daß der Behälter (10) aus einem lötbaren Material besteht und daß die Kühlflüssigkeit aus einem Alkohol besteht.
7. Vorrichtung nach Anspruch 5, dadurch gekennzeichnet, daß die Kühlflüssigkeit etwa ein Drittel des Volumens des Innenraums des Behälters (10) einnimmt.
8. Verwendung der Vorrichtung nach den Ansprüchen 1 bis 7 in einem Modul mit einem darin enthaltenen Substrat (11) und darauf angeordneten, mit integrierten Schaltungen versehenen Halbleiterplättchen, wobei der Behälter der Vorrichtung zwischen der Rückseite des Substrats und der Abdeckhaube (15) des Moduls angeordnet ist und der Verdampferabschnitt (16) des Behälters mit dem Substrat und der Kondensatorabschnitt (18) mit der Abdeckhaube (15) fest verbunden ist.

**0 013 362**

**Claims**

1. A heat transfer device comprising a closed container (10) having an evaporator section (16) and a condenser section (18) and a liquid coolant in the evaporator section (16), characterized in that the volume of the liquid coolant, its surface tension and the dimensions of the container are so adapted to each other that the application of heat to the eveporator section (16) results in the formation of a stable vapor bubble (17) substantially in the centre of the container and a flow of vapor across the vapor bubble (17) to the condenser section (18) where the vapor condenses, rejecting heat, the condensate subsequently returning through a continuous liquid film along the edge of the vapor bubble to the evaporator section for replenishing the liquid coolant in the evaporator section (16).

2. The device according to claim 1, characterized in that the container (10) has a cylindrical containment hole with the evaporator section (16) on one end and the condenser section (18) on the other.

3. The device according to claim 2, characterized in that the liquid coolant has a convace meniscus.

4. The device according to claim 2 or 3, characterized in that the length of the container (10) approximately equals its diameter.

5. The device according to claim 4, characterized in that the cylindrical wall of the container (10) is shaped as a bellows.

6. The device according to claim 5, characterized in that the container (10) is constructed of a solderable material and the liquid coolant consists of an alcohol.

7. The device according to claim 5, characterized in that the liquid coolant occupies approximately one-third the volume of the containment hold of the container (10).

8. Use of the device according to claims 1 to 7, in a module having embedded therein a substrate (11) on which semiconductor chips with integrated circuits are arranged, whereby the container of the device is arranged between the rear side of the substrate and the cap (15) of the module, the evaporator section (16) of the container is permanently fixed to the substrate, and the condenser section (18) is permanently fixed to the cap (15).

**Revendications**

1. Dispositif de transfert de chaleur comportant un récipient fermé (10) ayant une section d'évaporation (16) et une section de condensation (18), et un liquide de refroidissement dans la section d'évaporation (16), caractérisé en ce que le volume du liquide de refroidissement, sa tension de surface et les dimensions du récipient sont accordées de telle sorte que l'arrivée de la chaleur dans la section d'évaporation (16) a pour résultat une bulle de vapeur stable (17) située à peu près au centre du récipient, et que de la vapeur passe, en traversant la bulle de vapeur (17), dans la section de condensation (18) où elle se condense en dégageant de la chaleur, le fluide condensé refluant ensuite, sous forme de flux de luquide continu, le long du bor de la bulle de vapeur vers la section d'évaporation (16) pour régénérer le liquide de refroidissement dans la section d'évaporation (16).

2. Dispositif selon la revendication 1, caractérisé en ce que le récipient (10) comporte un intérieur cylindrique dont une extrémité comporte la section d'évaporation (16) et dont l'autre extrémité comporte la section de condensation (18).

3. Dispositif selon la revendication 2, caractérisé en ce que le liquide de refroidissement comporte un ménisque concave.

4. Dispositif selon la revendication 2 ou 3, caractérisé en ce que la longueur du récipient (10) correspond à peu près à son diamètre.

5. Dispositif selon la revendication 4, caractérisé en ce que la paroi cylindrique du récipient (10) forme un soufflet.

6. Dispositif selon la revendication 5, caractérisé en ce que le récipient (10) est fait d'un matériau soudable et que le liquide de refroidissement est de l'alcool.

7. Dispositif selon la revendication 5 caractérisé en ce que le liquide de refroidissement occupe environ un tiers du volume intérieur du récipient (10).

8. Utilisation du dispositif selon l'une quelconque des revendications 1 à 7, dans un module qui contient un substrat (11) sur lequel sont disposées des microplaquettes semi-conductrices comportant des circuits intégrés, le récipient du dispositif étant disposé entre la face arrière du substrat et le capot (15) du module et, la section d'évaporation (16) du récipient étant rigidement connectée au substrat et la section de condensation (18) au capot (15).

7

**FIG. 1**

STAND DER TECHNIK

Q-ABGABE
(KONDENSATOR)

Q = 0
(ADIABATISCH)

BEHÄLTER

Q-ZUFUHR
(VERDAMPFER)

FLÜSSIGKEITS-
SCHICHT

DAMPF

SIEDENDE
FLÜSSIGKEIT

**FIG. 2**

STAND DER TECHNIK

Q-ABGABE
KONDENSATOR

BEHÄLTER

PORÖSER DOCHT,
MIT FLÜSSIGKEIT
GETRÄNKT

Q = 0
(ADIABETISCH)

RÜCKLAUF DER
FLÜSSIGKEIT
DURCH KAPILLAR-
WIRKUNG

Q-ZUFUHR
(VERDAMPFER)

DAMPF

OFFENER
BEHALTER

KONDENSATORABSCHNITT

ZYLINDRISCHE BOHRUNG

VERDAMPFER ABSCHNITT

FLÜSSIGKEIT

## FIG. 3a

KONDENSAT

DICHTUNGSKAPPE

Q-ABGABE
(KONDENSATOR)

DICHT VER-
SCHLOSSENER
BEHÄLTER

ZYLINDRISCHE
BOHRUNG

FLÜSSIGKEIT

Q-ZUFUHR
(VERDAMPFER)

## FIG. 3b

DICHTUNGSKAPPE

KONDENSAT

KONDENSAT-
RÜCKLAUF

Q-ABGABE
(KONDENSATOR)

DAMPF-
BLASE

ZYLINDRISCHE
BOHRUNG

DICHT VER-
SCHLOSSENER
BEHÄLTER

Q-ZUFUHR
(VERDAMPFER)

## FIG. 3c

WÄRMESENKE

DICHTUNGSKAPPE

KÜHLFLÜSSIGK.

DICHT VER-
SCHLOSSENER
BEHÄLTER

DAMPF

DAMPFBLASE

KONDENSATRÜCK-
LAUF IM GE-
SCHLOSSENEN
KREISLAUF

Q - ABGABE
(KONDENSATOR)

0=Q (ADIABATISCH)

ZYLINDRISCHE
BOHRUNG

Q-ZUFUHR
(VERDAMPFER)

## FIG. 3d

20

14

15

18

17

10

19

16

11

12

13

## FIG. 4